# EUROPEAN PATENT APPLICATION

(11) **EP 4 021 156 A1**
(43) Date of publication of application: **29.06.2022**
(21) Application number: 19955118.5
(22) Date of filing: 27.12.2019
(51) Int. Cl.: H05K 7/20, F25B 1/00

(54) **FREQUENCY CONVERTER COOLING SYSTEM, APPARATUS IN WHICH FREQUENCY CONVERTER IS APPLIED, AND COOLING CONTROL METHOD**

(30) Priority: 05.12.2019 CN 201911235537
(71) Applicant: Zhuzhou CRRC Times Electric Co., Ltd., Zhuzhou, Hunan 412001 (CN)
(72) Inventor: HE, Yaping, Zhuzhou, Hunan 412001 (CN); DENG, Ming, Zhuzhou, Hunan 412001 (CN); HU, Jiaxi, Zhuzhou, Hunan 412001 (CN); LUO, He, Zhuzhou, Hunan 412001 (CN); GAO, Lushan, Zhuzhou, Hunan 412001 (CN); AO, En, Zhuzhou, Hunan 412001 (CN); MA, Ming, Zhuzhou, Hunan 412001 (CN); LI, Jia, Zhuzhou, Hunan 412001 (CN); HUANG, Yizhi, Zhuzhou, Hunan 412001 (CN); WEN, Liang, Zhuzhou, Hunan 412001 (CN); HAN, Zhicheng, Zhuzhou, Hunan 412001 (CN); GUO, Shihui, Zhuzhou, Hunan 412001 (CN); YANG, Zhuo, Zhuzhou, Hunan 412001 (CN); LIU, Yuxin, Zhuzhou, Hunan 412001 (CN); LI, Yu, Zhuzhou, Hunan 412001 (CN); YANG, Xing, Zhuzhou, Hunan 412001 (CN); MENG, Wenhui, Zhuzhou, Hunan 412001 (CN); HUANG, Qizhao, Zhuzhou, Hunan 412001 (CN); QIN, Canhua, Zhuzhou, Hunan 412001 (CN); ZHANG, Zhe, Zhuzhou, Hunan 412001 (CN)
(74) Representative: Petraz, Gilberto Luigi
(86) International application number: PCT/CN2019/129319
(87) International publication number: WO 2021/109296

(57) **Abstract**

Disclosed are a variable-frequency transmission cooling system, an apparatus in which a frequency converter is applied, and a cooling control method. The system comprises: a frequency converter cooling flow path, which comprises a first liquid-taking flow path, a first heat exchange assembly (4) and a first liquid-returning flow path, and performs heat exchange with a frequency converter assembly by means of the first heat exchange assembly (4); a first control device (21), which is arranged on the first liquid-taking flow path and/or the first liquid-returning flow path; a second control device (12), which is arranged on the first liquid-returning flow path; and a controller assembly, which is electrically connected to the frequency converter assembly, the first control device and the second control device, is used for ensuring that a frequency converter works at an adaptive temperature, and moreover, can further effectively adjust a front-back pressure difference of the frequency converter and solve problems such as condensation and overtemperature under extreme working conditions.

## Description

The present disclosure claims the priority of Chinese patent application No. 201911235537.5, filed on December 05, 2019 and entitled "Frequency converter cooling system, apparatus with frequency converter, and cooling control method", which is incorporated herein by reference in its entirety.

### Field of the Invention

The present disclosure relates to the technical field of cooling apparatuses, and in particular, to a frequency converter cooling system, an apparatus with a frequency converter, and a cooling control method.

### Background of the Invention

A frequency conversion transmission system is the core component of a frequency conversion air conditioner, heat loss of the frequency conversion transmission system is mainly from an internal power electronics, and the heat dissipation effect of the electronics will directly affect the operating reliability of a frequency converter. At present, the main heat dissipation manners of power electronics include air cooling, water cooling and refrigerant cooling. The air cooling is poor in heat dissipation capability and low in efficiency. The water cooling is complex in structure, where a frequency converter is heavy, and is high in cost. The refrigerant cooling has extremely high heat-dissipation efficiency and is simple in structure, and is thus the optimal cooling solution for a frequency converter. However, currently existing refrigerant cooling solutions still have various problems, such as, for example, overtemperature, condensation, etc., which may occur frequently in practical industrial operation.

Taking an air conditioning system as an example, the pipeline pressure and temperature characteristics in the air conditioning system at startup are completely different from those during normal operation. At system startup, the system pressure difference is not established, the flow is small, the flow of a refrigerant that flows through a frequency conversion system is small, and the refrigerating capacity is small, but power electronics in a frequency converter system will generate a large amount of heat, which can easily cause overtemperature. When air conditioning units of the system enters their normal operation, the system pressure difference becomes greater, and the flow of a refrigerant that flows through the frequency conversion system is larger, which can easily cause condensation on the electronics.

### Summary of the Invention

In order to overcome the problems discussed above, there is provided a frequency converter cooling system, an apparatus with a frequency converter, and a cooling control method.

According to a first aspect of the disclosure, a frequency converter cooling system is provided. The system includes a frequency converter cooling flow path, which includes a first liquid-taking flow path, a first heat exchange assembly and a first liquid-returning flow path, and performs heat exchange with a frequency converter assembly via the first heat exchange assembly; a first control device, which is provided in a quantity of at least one, and which is arranged on the first liquid-taking flow path and/or the first liquid-returning flow path for controlling a flow of a refrigerant liquid that flows through the first liquid-taking flow path and/or for controlling a flow of a refrigerant liquid that flows through the first liquid-returning flow path; a second control device, which is arranged on the first liquid-returning flow path for controlling a flowing direction of the refrigerant liquid that flows through the first liquid-returning flow path, so that evaporative heat dissipation of a corresponding power can be performed on a refrigerant liquid discharged in each flowing direction; and a controller assembly, which is electrically connected to the frequency converter assembly, the first control device and the second control device for controlling the operation of the first control device and the operation of the second control device.

In an embodiment, the controller assembly is configured for controlling the operation of the first control device and/or the operation of the second control device according to an output power of the frequency converter assembly.

In an embodiment, the system further includes a module temperature measurement device, which is arranged on the first heat exchange assembly, and which is electrically connected to the controller assembly for collecting a temperature of the frequency converter assembly and for uploading a temperature parameter to the controller assembly, so that the controller assembly controls the operation of the first control device and/or the operation of the second control device according to the collected temperature.

In an embodiment, the first liquid-returning flow path includes a first liquid-returning branch and at least two second liquid-returning branches. Each of the second liquid-returning branches is configured for discharging a flowing refrigerant liquid, so that evaporative heat dissipation of a corresponding power can be performed on the discharged refrigerant liquid. An output end of the first liquid-returning branch is connected to the at least two second liquid-returning branches. The second control device is configured for controlling the connection and disconnection between the first liquid-returning branch and the at least two second liquid-returning branches, so as to control a flowing direction of the refrigerant liquid that flows through the first liquid-returning branch. When the first control device is arranged on the first liquid-returning flow path, the first control device is arranged on the first liquid-returning branch.

In an embodiment, the second control device is provided in a quantity corresponding to the quantity of the second liquid-returning branches. The second control devices are respectively arranged on the corresponding second liquid-returning branches.

In an embodiment, the system further includes at least one second cooling branch that is connected to the frequency converter cooling flow path in parallel, the second cooling branch including a second heat exchanger for performing heat exchange with the frequency converter assembly.

In an embodiment, the first cooling branch further includes a third control device, which is provided in a quantity corresponding to the quantity of the second cooling branch, and which is located upstream of the corresponding second heat exchanger. The third control device is electrically connected to the controller assembly for receiving an instruction from the controller assembly to control a flow of a refrigerant liquid that flows through the second cooling branch.

In an embodiment, the system further includes a plurality of humidity measurement devices, each of which is electrically connected to the controller assembly for collecting humidity of the frequency converter assembly and for uploading a humidity parameter to the controller assembly.

According to a second aspect of the disclosure, an apparatus with a frequency converter is provided, including a refrigeration apparatus unit, a frequency converter assembly and the above-mentioned frequency converter cooling system. The refrigeration apparatus unit includes a condenser, an evaporator and a flash-tank, which are sequentially connected. Further, an input end of the first liquid-taking flow path of the frequency converter cooling flow path and an input end of the at least one second cooling branch are both connected to an output end of the condenser. Output ends of the at least two second liquid-returning branches are respectively connected to an input end of the evaporator and an input end of the flash-tank.

According to a third aspect of the disclosure, a frequency converter cooling method is provided, which is applied to the above-mentioned apparatus with a frequency converter. The method includes the following steps.

At step S11, an output power of a frequency converter power assembly is acquired.

At step S12, it is determined whether an output power of the frequency converter assembly meets a first preset condition. The first preset condition includes the output power of the frequency converter assembly being less than a set minimum power, or the output power of the frequency converter assembly being greater than or equal to a set maximum power.

At step S13, if the first preset condition is met, a second control device located on a second liquid-returning branch corresponding to a flash-tank is controlled to close a flow path between the second liquid-returning branch corresponding to the flash-tank and the flash-tank, and a second control device located on a second liquid-returning branch corresponding to an evaporator is controlled to open a flow path between the second liquid-returning branch corresponding to the evaporator and the evaporator, so as to ensure a reflux refrigerant liquid entering the evaporator.

Otherwise, the second control device located on the second liquid-returning branch corresponding to the flash-tank is controlled to open the flow path between the second liquid-returning branch corresponding to the flash-tank and the flash-tank, and the second control device located on the second liquid-returning branch corresponding to the evaporator is controlled to close the flow path between the second liquid-returning branch corresponding to the evaporator and the evaporator.

Optionally, the method further includes the following steps.

At step S14, a temperature of the frequency converter power assembly is acquired.

At step S15, it is determined whether the temperature of the frequency converter power assembly meets a second preset condition. The second preset condition includes the temperature of the frequency converter power assembly being within a set interval of temperature of the frequency converter power assembly.

At step S16, if the second preset condition is met, a first control device located on a first liquid-taking flow path is controlled to be switched on, and a first control device on a first liquid-returning flow path is controlled, so as to control the flow of the first liquid-returning flow path per unit of time.

Otherwise, the first control device located on the first liquid-returning flow path is controlled to be switched on, and the first control device on the first liquid-taking flow path is controlled, so as to control the flow of the first liquid-taking flow path per unit of time.

Optionally, the method further includes the following steps.

At step S17, a temperature of an electric motor assembly is acquired.

At step S 18, it is determined whether the temperature of the electric motor assembly meets a third preset condition. The third preset condition includes the temperature of the electric motor being lower than a target temperature of the electric motor.

At step S19, according to a determination result, a third control device corresponding to the electric motor assembly is controlled to start, so as to adjust the temperature and humidity of the electric motor assembly.

Optionally, the method further includes the following steps.

At step S20, a temperature of a frequency converter heat dissipation assembly is acquired.

At step S21, it is determined whether the temperature of the frequency converter heat dissipation assembly meets a first preset condition. The first preset condition includes an in-cabinet temperature of the frequency converter heat dissipation assembly being within a set interval of an in-cabinet temperature of the frequency converter heat dissipation assembly.

At step S22, according to a determination result, a third control device corresponding to the frequency converter heat dissipation assembly is controlled to start, so as to adjust the temperature and humidity of the frequency converter heat dissipation assembly.

The disclosure will have the following beneficial effects: a second control device on a second liquid-returning flow path can be controlled by a controller assembly, so as to switch a flowing circuit of a refrigerant liquid on the second liquid-returning flow path, thereby realizing one-stage cooling adjustment. A first control device on a first liquid-taking flow path and/or a first liquid-returning flow path can also be controlled, so as to limit the flow of a refrigerant liquid flowing into a first heat exchange assembly and/or flowing out of the first heat exchange assembly, and effectively adjust a differential pressure across a frequency converter, thereby ensuring that the frequency converter works within a suitable temperature range, and solving the problem of condensation under a low-load condition.

### Brief Description of the Drawings

Fig. 1 is an overall structural schematic diagram of an apparatus with a frequency converter in an embodiment of the disclosure;
Fig. 2 is a simplified structural diagram of a controller assembly in an embodiment of the disclosure;
Fig. 3 is a first structural schematic diagram of an apparatus with a frequency converter in an embodiment of the disclosure;
Fig. 4 is a second structural schematic diagram of an apparatus with a frequency converter in an embodiment of the disclosure;
Fig. 5 is a first functioning principle diagram of an apparatus with a frequency converter in an embodiment of the disclosure;
Fig. 6 is a second functioning principle diagram of an apparatus with a frequency converter in an embodiment of the disclosure;
Fig. 7 is a third functioning principle diagram of an apparatus with a frequency converter in an embodiment of the disclosure; and
Fig. 8 is a fourth functioning principle diagram of an apparatus with a frequency converter in an embodiment of the disclosure.

### List of reference numbers

- 1: Frequency converter body
- 2: Cooling throttling device
- 3: Flow control device
- 4: First heat exchange assembly
- 5: Power module
- 6: Temperature adjustment device
- 7: Temperature decrease device
- 8: Electric motor assembly
- 9: Electric motor temperature measurement device
- 12: Second control device
- 13: Flash-tank
- 14: Evaporator
- 15: Compressor
- 16: Condenser
- 17: Humidity measurement device
- 18: Apparatus throttling valve
- 19: Module temperature measurement device
- 20: In-cabinet temperature measurement device
- 21: First control device
- 22: Frequency conversion transmission system
- 23: External pipeline system
- 24: Frequency converter heat dissipation assembly

### Detailed Description of the Embodiments

It should be noted that the embodiments described herein are merely illustrative of the disclosure and are not intended to limit the disclosure.

In the following description, postfixes such as "module", "part" or "unit" for representing elements are used merely for facilitating the description of the disclosure, and themselves do not have specified meanings. Therefore, "module", "part" or "unit" may be used in a mixed manner.

The structural and functional details disclosed herein are merely representative, and are merely used for describing exemplary embodiments of the disclosure. However, the disclosure can be implemented by many alternatives, and should not be interpreted as being limited to only the embodiments set forth herein.

It should be noted that although various unit are described by using the terms "first", "second", etc., these units should not be limited by these terms. The use of these terms is merely for distinguishing one unit from another unit. For example, without departing from the scope of the exemplary embodiments, a first unit can be referred to as second unit, and similarly, a second unit can be referred to as first unit. The term "and/or" used herein includes any and all combinations of one or more of associated items that are listed.

It should be noted that when one unit is mentioned to be "connected" or "coupled" to another unit, the unit can be directly connected or coupled to another unit, or there can be an intermediate unit. By contrast, when one unit is mentioned to be "directly connected" or "directly coupled" to another unit, there is no intermediate unit. Other words (for example, "between..." relative to "directly between...", "close to..." relative to "directly close to...", etc.) used for describing the relationship between units should be interpreted in a similar manner.

The terms used herein are merely used for describing the embodiments and are not intended to limit the exemplary embodiments. The singular forms "one" and "a/an" are also intended to include the plural forms, unless the context clearly indicates otherwise. It should also be noted that the terms "including" and/or "containing" used herein specify the presence of the features, integers, steps, operations, units and/or components, but the presence or addition of one or more other features, integers, steps, operations, units, components and/or a combination of them.

It should also be noted that in some alternative implementations, the mentioned functions/actions can be implemented in an order different from that indicated in the accompanying drawings. For example, depending on the functions/actions involved, two diagrams that are shown in succession can actually be executed at the same time, or sometimes can be executed in opposite orders.

In order to facilitate the understanding of the embodiments of the disclosure, the technical solutions of the disclosure are described in details below by way of several embodiments.

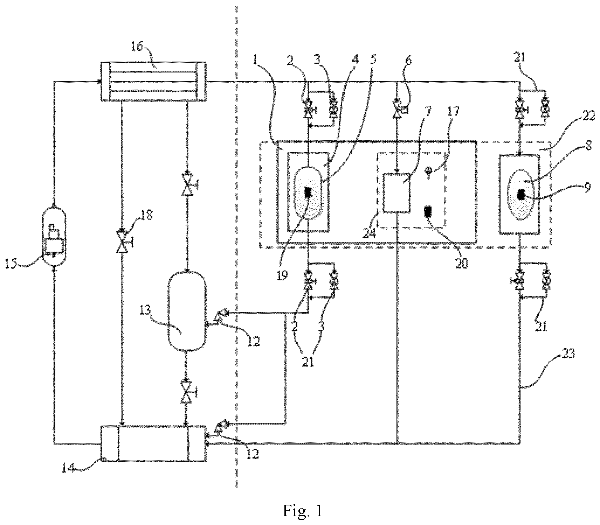

As shown in Fig. 1, a first embodiment of the disclosure provides a frequency converter cooling system. The system includes a frequency converter cooling flow path, which includes a first liquid-taking flow path, a first heat exchange assembly 4 and a first liquid-returning flow path, and performs heat exchange with a frequency converter assembly via the first heat exchange assembly 4; a first control device 21, which is provided in a quantity of at least one, and which is arranged on the first liquid-taking flow path and/or the first liquid-returning flow path for controlling a flow of a refrigerant liquid that flows through the first liquid-taking flow path and/or for controlling a flow of a refrigerant liquid that flows through the first liquid-returning flow path; a second control device 12, which is arranged on the first liquid-returning flow path for controlling a flowing direction of the refrigerant liquid that flows through the first liquid-returning flow path, so that evaporative heat dissipation of a corresponding power can be performed on a refrigerant liquid discharged in each flowing direction; and a controller assembly, which is electrically connected to the frequency converter assembly, the first control device 21 and the second control device 12 for controlling the operation of the first control device 21 and the operation of the second control device 12.

Thus, the second control device 12 on the second liquid-returning flow path can be controlled by the controller assembly, so as to switch a flowing circuit of a refrigerant liquid on the second liquid-returning flow path, thereby realizing one-stage cooling adjustment. The first control device 21 on the first liquid-taking flow path and/or the first liquid-returning flow path can also be controlled, so as to limit the flow of a refrigerant liquid flowing into the first heat exchange assembly 4 and/or flowing out of the first heat exchange assembly 4, and effectively adjust a differential pressure across a frequency converter, thereby ensuring that the frequency converter works within a suitable temperature range.

As shown in Fig. 1, the first embodiment of the disclosure provides an apparatus with a frequency converter, the apparatus including, but not limited to an air conditioner and a refrigerator.

In an embodiment, the apparatus includes a refrigeration apparatus unit, a frequency conversion transmission cooling circulation system and a frequency converter cooling system. The refrigeration apparatus unit includes, but not limited to a flash-tank 13, a condenser 16, an evaporator 14, a compressor 15 and an apparatus throttling valve 18. The frequency conversion transmission cooling circulation system contains a frequency conversion transmission system 22 and an external pipeline system 23. The frequency conversion transmission system 22 further includes the frequency converter assembly, and the external pipeline system 23 and the frequency converter cooling system have multiple pipelines that overlap with each other.

The frequency converter assembly is a working assembly of a frequency converter, and to a certain extent, the frequency converter assembly can replace the frequency converter. The frequency converter assembly includes, but not limited to a frequency converter power assembly, a frequency converter heat dissipation assembly 24 and an electric motor assembly 8. The frequency converter power assembly and the frequency converter heat dissipation assembly 24 form a frequency converter body 1.

The frequency converter power assembly includes at least one power module 5. As shown in Fig. 1, the frequency conversion transmission system 22 is provided with one frequency converter power assembly.

In an embodiment, the frequency converter cooling system includes the frequency converter cooling flow path, at least two second cooling branches, a first control device 21, a second control device 12 and a controller assembly. The frequency converter cooling flow path is connected to each of the second cooling branches in parallel.

The frequency converter cooling flow path includes the first liquid-taking flow path, the first heat exchange assembly 4 and the first liquid-returning flow path, and performs heat exchange with a frequency converter assembly via the first heat exchange assembly 4.

Further, an input end of the first liquid-taking flow path of the frequency converter cooling flow path and an input end of the at least one second cooling branch are both connected to an output end of the condenser 16.

In this embodiment, the structure of the frequency converter assembly is not limited, except as by this embodiment. For example, as shown in Fig. 1, the frequency converter assembly can be a frequency converter power assembly.

At least one first control device 21 is provided, which may be respectively arranged on the first liquid-taking flow path and/or the first liquid-returning flow path for controlling a flow of a refrigerant liquid that flows through the first liquid-taking flow path and/or for controlling a flow of a refrigerant liquid that flows through the first liquid-returning flow path.

It should be noted that using a control device on a flow path to control the flow of a refrigerant liquid that flows through the flow path, which is involved herein, means that opening and closing of the flow path can be controlled by the control device on the flow path.

As shown in Fig. 1, a first control device 21 is arranged on each of the first liquid-taking flow path and the first liquid-returning flow path.

The first control device 21 includes, but not limited to a cooling throttling device 2 and a flow control device 3, which are connected to each other in parallel, or a control valve for controlling a flow or a flowing direction of a flowing refrigerant liquid. As shown in Fig. 1, the first control device 21 is provided with a cooling throttling device 2 and a flow control device 3, which are connected to each other in parallel.

Further, an input end of the first liquid-taking flow path is connected to an output end of the condenser 16.

The second control device 12 is arranged on the first liquid-returning flow path for controlling a flowing direction of the refrigerant liquid that flows through the first liquid-returning flow path, so that evaporative heat dissipation of a corresponding power can be performed on a refrigerant liquid discharged in each flowing direction.

The controller assembly is electrically connected to the frequency converter assembly, the first control device 21 and the second control device 12.

In another embodiment, the controller assembly can control the operation of the first control device 21 and/or the operation of the second control device 12 according to an output power of the frequency converter assembly.

In another embodiment, the frequency converter cooling system further includes a module temperature measurement device 19, which is arranged on the first heat exchange assembly 4, and which is electrically connected to the controller assembly for collecting a temperature of the frequency converter assembly (for example, the power module 5) and for uploading a temperature parameter to the controller assembly, so that the controller assembly controls the operation of the first control device 21 and/or the operation of the second control device 12 according to the collected temperature.

The controller assembly controlling the operation of the control device, as disclosed herein, involves the controller assembly controlling the switching on and off of the control device, and an operation state of the control device. For example, the controller assembly controls, by controlling the first control device 21, the flow of a refrigerant liquid that flows through the first liquid-taking flow path.

The output power of the frequency converter assembly can be acquired by an external apparatus and then forwarded to the controller assembly. Certainly, the output power of the frequency converter assembly can also be directly acquired by the controller assembly. It is also possible to acquire related data by an external device and then forward same to the controller assembly, and the output power of the frequency converter assembly is then generated by the controller assembly according to the related data. It is also possible to directly acquire related data by the controller assembly, and the output power of the frequency converter assembly is then generated by the controller assembly according to the related data. The related data includes, but not limited to parameters such as a current and a voltage. In this embodiment, a source of the output power of the frequency converter assembly is not limited, except as by this embodiment.

In another embodiment, the module temperature measurement device 19 uploads a collected temperature to the controller assembly, and thus, the controller assembly controls the operation of the second control device 12 according to the output power of the frequency converter assembly, and the controller assembly also controls the operation of the first control device 21 according to temperature collected by the module temperature measurement device 19.

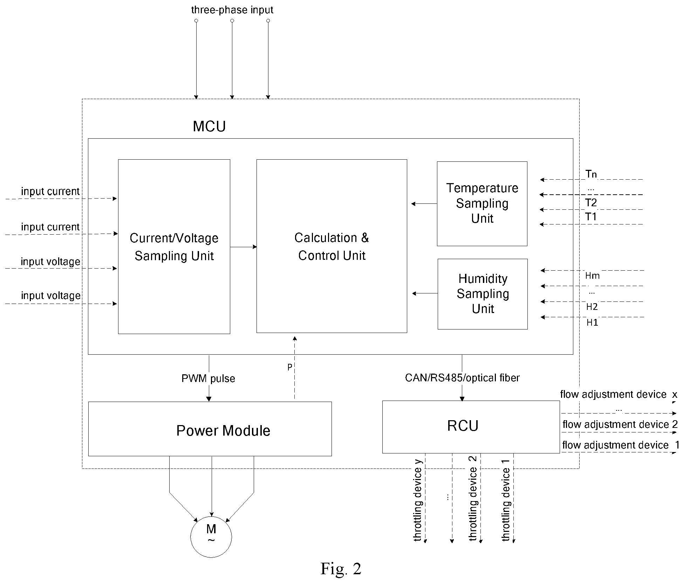

As shown in Fig. 2, the controller assembly mainly includes an MCU and an RCU. The MCU further includes a current/voltage sampling unit, a calculation and control unit, a temperature sampling unit and a humidity sampling unit. The MCU is responsible for collecting, calculating and controlling data in the frequency converter, such as temperature, humidity, current, voltage, etc., and sending a target state of a refrigerant cooling execution element upon calculation to the RCU, and the RCU then adjusts the execution element to the target state.

When the system runs, the MCU collects data in the frequency converter, such as temperature, humidity, current, voltage, once in a period. The current data includes an input current and an output current. The voltage data includes an input voltage and an output voltage. Further, the temperature and humidity of the frequency converter are collected by multiple temperature sampling circuits and multiple humidity sampling circuits.

In another embodiment, the first liquid-returning flow path includes a first liquid-returning branch and at least two second liquid-returning branches. Each of the second liquid-returning branches is configured for discharging a flowing refrigerant liquid, so that evaporative heat dissipation of a corresponding power can be performed on the discharged refrigerant liquid. An output end of the first liquid-returning branch is connected to the at least two second liquid-returning branches. The second control device 12 is configured for controlling connection and disconnection between the first liquid-returning branch and the at least two second liquid-returning branches, so as to control a flowing direction of the refrigerant liquid that flows through the first liquid-returning branch. When the first control device 21 is arranged on the first liquid-returning flow path, the first control device 21 is arranged on the first liquid-returning branch.

Additionally, in another embodiment, the second control device 12 is provided in a quantity corresponding to the quantity of the second liquid-returning branches. Each second control devices 12 is respectively arranged on a corresponding second liquid-returning branch.

As shown in Fig. 1, the first liquid-returning flow path is provided with two second liquid-returning branches. One of the second liquid-returning branches is connected to the flash-tank 13, and the other of the second liquid-returning branches is connected to the evaporator 14. Further, a second control device 12 is arranged on each of the two second liquid-returning branches. The second control device 12 here is a control valve for controlling the flow or the flowing direction of a flowing refrigerant liquid. For example, the second control device 12 is an electromagnetic valve.

Therefore, in another embodiment, the controller assembly controls the operation of the second control device 12 according to the output power of the frequency converter assembly, and the controller assembly also controls the operation of the first control device 21 according to the temperature collected by the module temperature measurement device 19, such that dual-stage adjustment and a super-wide refrigeration range can be realized.

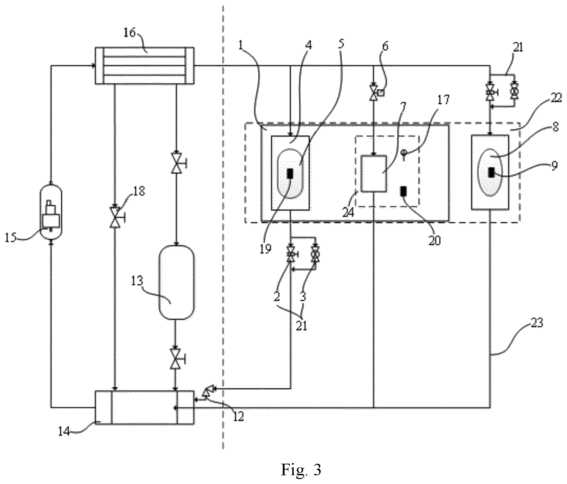

As shown in Fig. 3, when it is determined that the output power of the frequency converter assembly is less than a set minimum power or the output power of the frequency converter assembly is greater than or equal to a set maximum power, the controller assembly controls a second control device 12 located on a second liquid-returning branch corresponding to the flash-tank 13 to close a flow path between the second liquid-returning branch corresponding to the flash-tank 13 and the flash-tank 13, and also controls a second control device 12 located on a second liquid-returning branch corresponding to the evaporator 14 to open a flow path between the second liquid-returning branch corresponding to the evaporator 14 and the evaporator 14, so as to ensure a reflux refrigerant liquid entering the evaporator 14, thereby performing one-stage cooling adjustment. Moreover, the controller assembly controls a first control device 21 located on the first liquid-taking flow path to be switched on, so as to ensure that the first liquid-taking flow path remains open, and also controls a first control device 21 located on the first liquid-returning flow path to control the flow of the refrigerant liquid that flows through the first heat exchange assembly 4, so as to control the flow of the refrigerant liquid entering the evaporator 14 after being subjected to heat exchange, thereby realizing two-stages cooling adjustment, such that the frequency converter assembly operating under an optimal temperature is realized by the refrigerant liquid flowing out of the condenser 16. At this time, the first control device 21 for controlling the flow of the refrigerant liquid that has been subjected to heat exchange is located at a rear end of the frequency converter assembly (for example, the above-mentioned frequency converter power assembly), so as to effectively adjust a differential pressure across the frequency converter to be adapted to various complex working conditions.

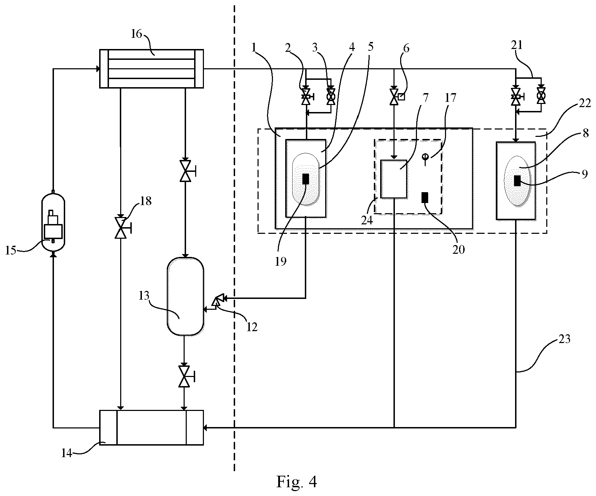

In addition, as shown in Fig. 4, when it is determined that the output power of the frequency converter assembly is greater than the set minimum power and the output power of the frequency converter assembly is less than the set maximum power, the controller assembly controls the second control device 12 located on the second liquid-returning branch corresponding to the flash-tank 13 to open a flow path between the second liquid-returning branch corresponding to the flash-tank 13 and the flash-tank 13, and also controls the second control device 12 located on the second liquid-returning branch corresponding to the evaporator 14 to close a flow path between the second liquid-returning branch corresponding to the evaporator 14 and the evaporator 14, so as to ensure a reflux refrigerant liquid entering the flash-tank 13, thereby performing one-stage cooling adjustment. Moreover, the controller assembly controls the first control device 21 located on the first liquid-returning flow path to control the flow of the refrigerant liquid that flows through the first liquid-taking flow path, that is, controlling the flow of the refrigerant liquid that has been subjected to heat exchange, and also controls the first control device 21 located on the first liquid-returning flow path to be switched on, so as to ensure fluid communication through the first liquid-returning flow path and to ensure discharging of the refrigerant liquid that flows through the first heat exchange assembly 4, thereby realizing two-stages cooling adjustment, such that the frequency converter assembly operating under an optimal temperature is realized by the refrigerant liquid flowing out of the condenser 16. At this time, the first control device 21 for controlling the flow of the refrigerant liquid that has been subjected to heat exchange is located at a front end of the frequency converter assembly (for example, the above-mentioned frequency converter power assembly), so as to effectively solve the problem of condensation under an extreme working condition.

Additionally, in another embodiment, the frequency converter cooling system further includes a plurality of temperature measurement devices and a plurality of humidity measurement device. Each of the temperature measurement devices is electrically connected to the controller assembly for collecting a temperature of a corresponding frequency converter assembly and for uploading a temperature parameter to the controller assembly. The above-mentioned module temperature measurement device 19 is merely described as one implementation of the temperature measurement device. Each of the humidity measurement devices is electrically connected to the controller assembly for collecting humidity of a corresponding frequency converter assembly and for uploading a humidity parameter to the controller assembly.

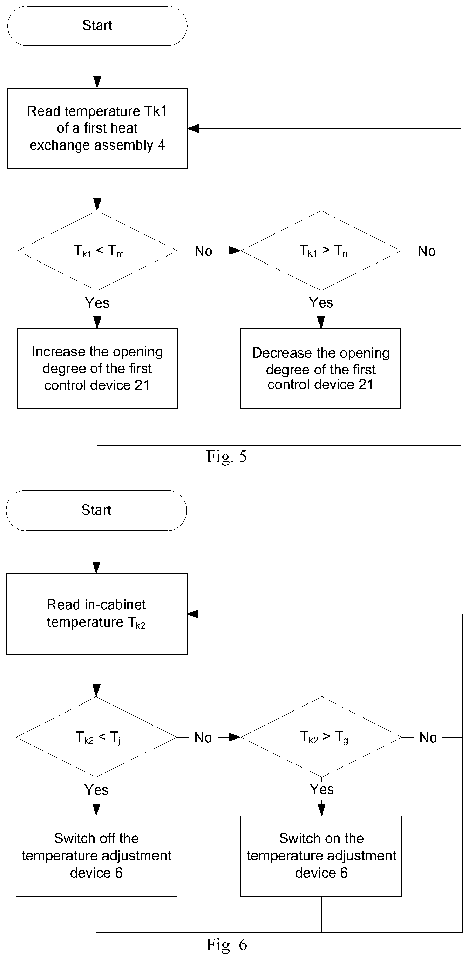

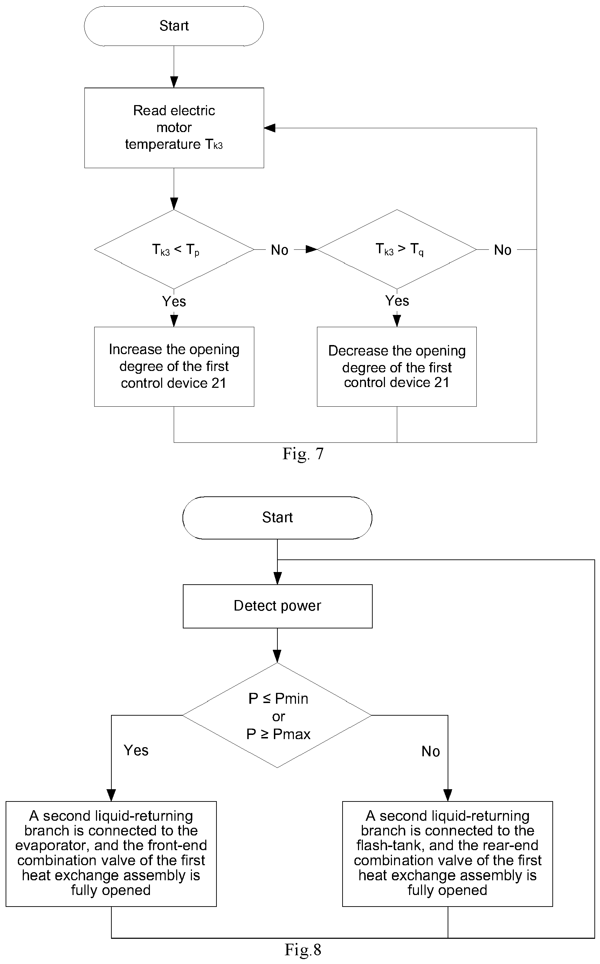

As shown in Figs. 1, 3, 4, 5 and 8, taking the frequency converter power assembly as an example, one frequency converter power assembly is provided in this embodiment, and each frequency converter power assembly includes at least one power module 5. The power module 5 is arranged in the first heat exchange assembly 4, and the module temperature measurement device 19 is arranged on the first heat exchange assembly 4. When it is determined that the output power P (i.e. the operating power of the power module 5) of the frequency converter assembly is less than the set minimum power or the output power P of the frequency converter assembly is greater than or equal to the set maximum power, the controller assembly controls the second control device 12 located on the second liquid-returning branch corresponding to the flash-tank 13 to close a flow path between the second liquid-returning branch corresponding to the flash-tank 13 and the flash-tank 13, and also controls the second control device 12 located on the second liquid-returning branch corresponding to the evaporator 14 to open a flow path between the second liquid-returning branch corresponding to the evaporator 14 and the evaporator 14, so as to perform one-stage cooling adjustment. The temperature Tₖ₁ (Tₖ₁ can be a single value, and can also be a mean value of multiple values) collected by the module temperature measurement device 19 is periodically acquired to be compared with a target temperature interval (the target temperature interval is from Tₘ to Tₙ, where Tₘ < Tn). As shown in Fig. 3, if Tₘ ≤ Tₖ₁ ≤ Tₙ, the controller assembly adjusts the opening degree of the first control device 21 located on the first liquid-taking flow path, so as to adjust the flowing refrigerant liquid per unit of time. Certainly, the first control device 21 on the first liquid-returning flow path can be opened to the greatest opening degree.

As shown in Fig. 4, if Tₖ₁ ≤ Tₘ or Tₖ₁ ≥ Tₙ, the controller assembly adjusts the opening degree of the first control device 21 located on the first liquid-returning flow path, so as to adjust the flowing refrigerant liquid per unit of time. Certainly, the first control device 21 on the first liquid-taking flow path can be opened to the greatest opening degree. For example, if Tₖ₁ ≤ Tₘ, the controller assembly increases the opening degree of the first control device 21 located on the first liquid-returning flow path, so as to adjust the flowing refrigerant liquid per unit of time; and if Tₖ₁ ≥ Tₙ, the controller assembly decreases the opening degree of the first control device 21 located on the first liquid-taking flow path, so as to reduce the flowing refrigerant liquid per unit of time. Within a circulation period, it is ensured that Tₖ₁ is always higher than T_{d} (T_{d} is the in-cabinet dew-point temperature of the frequency converter), so as to perform two-stage cooling adjustment. Such a setting keeps the equipment running at a suitable temperature to prevent condensation.

Certainly, the following settings can also be performed. With continued reference to Figs. 1, 3, 4, 5 and 8, as shown in Fig. 4, if Tₘ ≤ Tₖ₁ ≤ Tₙ, the controller assembly adjusts the opening degree of the first control device 21 located on the first liquid-returning flow path, so as to adjust the flowing refrigerant liquid per unit of time. Certainly, the first control device 21 on the first liquid-taking flow path can be opened to the greatest opening degree.

As shown in Fig. 3, if Tₖ₁ ≤ Tₙ, the controller assembly decreases the opening degree of the first control device 21 on the first liquid-returning flow path, so as to reduce the flowing refrigerant liquid per unit of time. Certainly, the first control device 21 on the first liquid-taking flow path can be opened to the greatest opening degree. If Tₖ₁ ≥ Tₙ, the controller assembly increases the opening degree of the first control device 21 on the first liquid-returning flow path, so as to increase the flowing refrigerant liquid per unit of time. Certainly, the first control device 21 on the first liquid-taking flow path can be opened to the greatest opening degree. Within a circulation period, it is ensured that Tₖ₁ is always higher than T_{d} (T_{d} is the in-cabinet dew-point temperature of the frequency converter). Such a setting keeps the equipment running at a suitable temperature to prevent condensation.

The cooling throttling device 2 and the flow control device 3 in the first control device 21 can be integrated with each other.

In another embodiment, the frequency converter cooling system further includes at least one second cooling branch that is connected to the frequency converter cooling flow path in parallel, the second cooling branch including a second heat exchanger for performing heat exchange with the frequency converter assembly. The second cooling branch can further realize adjustment of the temperature of the frequency converter.

Further, the first cooling branch includes a third control device, which is provided in a quantity corresponding to the quantity of the second cooling branch, and which is located upstream of the corresponding second heat exchanger. The third control device is electrically connected to the controller assembly for receiving an instruction from the controller assembly to control a flow of a refrigerant liquid that flows through the second cooling branch.

In an embodiment, as shown in Figs. 1, 3 and 4, the frequency converter cooling system further includes at least two second cooling branches. One of the second cooling branches is configured for performing heat exchange with the frequency converter heat dissipation assembly 24, and the other of the second cooling branches is configured for performing heat exchange with the electric motor assembly 8.

In an embodiment, as shown in Figs. 1, 3, 4 and 6, the second cooling branch for performing heat exchange with the frequency converter heat dissipation assembly 24 is described.

The second cooling branch for performing heat exchange with the frequency converter heat dissipation assembly 24 includes a second liquid-taking flow path, a second heat exchanger and a second liquid-returning flow path. An input end of the second liquid-taking flow path is connected to an output end of the condenser 16, and an output end of the second liquid-returning flow path is connected to the input end of the evaporator 14. The temperature adjustment device 6 is also arranged on the second liquid-taking flow path. In this embodiment, the temperature adjustment device 6 is configured for adjusting the flow of the refrigerant liquid that flows through the second liquid-taking flow path.

Certainly, in this embodiment, at least one second cooling branches for performing heat exchange with the frequency converter heat dissipation assembly 24 can be provided, which is not limited in this embodiment.

The frequency converter heat dissipation assembly 24 includes a temperature decrease device 7 and an in-cabinet temperature measurement device 20. Additionally, in this embodiment, the solution is described by replacing the above-mentioned second heat exchanger (not shown) with the temperature decrease device 7.

In an embodiment, the condenser 16 is connected to the temperature adjustment device 6 and the temperature decrease device 7 in sequence via the second liquid-taking flow path, and is then connected to the evaporator 14 via the second liquid-returning flow path. A refrigerant liquid is output from the condenser 16, passes through the temperature adjustment device 6 and the temperature decrease device 7 in sequence, and finally flows into the evaporator 14 through the second liquid-returning flow path. Further, the temperature decrease device 7 is configured to adjust the temperature and humidity of the frequency converter heat dissipation assembly 24, and certainly also adjusts the in-cabinet temperature and humidity of the frequency converter. Whether a limit range of an in-cabinet temperature Tₖ₂ satisfies Tⱼ ≤ Tₖ₂ ≤ T_{g} is determined according to humidity HR collected by the humidity measurement device 17, in-cabinet temperature Tₖ₂ acquired by the temperature measurement device, and the in-cabinet dew-point temperature T_{d} of the frequency converter. If so, no processing is performed, if Tₖ₂ < Tⱼ, the controller assembly switches off the temperature adjustment device 6, or if Tₖ₂ > T_{g}, the controller assembly switches on the temperature adjustment device 6, so that the frequency converter works within suitable in-cabinet temperature and humidity ranges.

In an embodiment, as shown in Figs. 1, 3, 4 and 7, the second cooling branch for performing heat exchange with the electric motor assembly 8 is described.

The electric motor assembly 8 is a primary working component of an electric motor, and to a certain extent, the electric motor assembly 8 can replace the electric motor.

The second cooling branch for performing heat exchange with the electric motor assembly 8 includes a third liquid-taking flow path, a third heat exchanger and a third liquid-returning flow path. An input end of the third liquid-taking flow path is connected to an output end of the condenser 16, and an output end of the third liquid-returning flow path is connected to the input end of the evaporator 14. A first control device 21 is also arranged on the third liquid-taking flow path. The third heat exchanger performs heat exchange with the electric motor assembly. An electric motor temperature measurement device for collecting the temperature of the electric motor assembly is also arranged in the electric motor assembly. In addition, the quantity of the first control device 21 on the third cooling branch can be decreased or increased as appropriate. A refrigerant liquid is output from the condenser 16, then flows into the third heat exchanger, and flows into the evaporator 14 after being subjected to heat exchange with the electric motor via the third heat exchanger. The temperature Tₖ₃ collected by the electric motor temperature measurement device 9 is periodically acquired to be compared with a target temperature interval of the electric motor (the target temperature interval of the electric motor is from Tₚ to T_{q}, where Tₚ < T_{q}). If Tₚ ≤ Tₖ₃ ≤ T_{q}, no processing is performed, if Tₖ₃ ≤ Tₚ, the controller assembly decreases the opening degree of the first control device 21 on the third liquid-taking flow path, so as to reduce the flowing refrigerant liquid per unit of time, or if Tₖ₃ ≥ T_{q}, the controller assembly increases the opening degree of the first control device 21 on the third liquid-taking flow path, so as to increase the flowing refrigerant liquid per unit of time, so that the electric motor works within a suitable temperature range.

It should be noted that neither the second cooling branch for performing heat exchange with the frequency converter heat dissipation assembly 24 nor the second cooling branch for performing heat exchange with the electric motor assembly 8 depends on the output power of the frequency converter, and it is only necessary to work at a temperature that meets a corresponding temperature condition.

A second embodiment of the disclosure provides a frequency converter cooling method, which is applied to the above-mentioned apparatus with a frequency converter. The method includes the following steps.

At step S 11, an output power of a frequency converter power assembly (for example, the above-mentioned power module 5) is acquired.

At step S12, it is determined whether the output power of the frequency converter assembly meets a first preset condition. The first preset condition includes the output power of the frequency converter assembly being less than a set minimum power, or the output power of the frequency converter assembly being greater than or equal to a set maximum power.

If so, the second control device 12 is controlled to close a flow path between the second liquid-returning branch corresponding to the flash-tank 13 and the flash-tank 13, and to open a flow path between the second liquid-returning flow path corresponding to the evaporator 14 and the evaporator 14, and the following step S131 is executed.

At step S131, the temperature and humidity of the frequency converter heat dissipation assembly 24 in the frequency converter, the temperature of the frequency converter assembly, and the temperature of the electric motor assembly 8 are measured.

When the temperature and humidity of the frequency converter heat dissipation assembly 24 do not meet the first preset condition, the third control device on the second cooling branch for performing heat exchange with the frequency converter heat dissipation assembly 24 is controlled to control the flow of a refrigerant liquid that flows through the second cooling branch for performing heat exchange with the frequency converter heat dissipation assembly 24, thereby realizing adjustment of the temperature and humidity of the frequency converter heat dissipation assembly 24. The first preset condition includes an in-cabinet temperature of the frequency converter heat dissipation assembly 24 being within a set interval of an in-cabinet temperature of the frequency converter heat dissipation assembly 24.

When the temperature of the frequency converter power assembly does not meet the second preset condition, the first control device 21 located on the first liquid-taking flow path is controlled to be switched on, and the first control device 21 located on the first liquid-returning flow path is controlled to control a flow of a refrigerant liquid that flows through the first heat exchange assembly 4, so as to adjust the temperature of the frequency converter power assembly. The second preset condition includes the temperature of the frequency converter power assembly being within a set interval of temperature of the frequency converter power assembly.

When the temperature of the electric motor assembly 8 does not meet the third preset condition, the third control device on the second cooling branch for performing heat exchange with the electric motor assembly 8 is controlled to control a flow of a refrigerant liquid that flows through the second cooling branch for performing heat exchange with the electric motor assembly 8, thereby realizing adjustment of the temperature and humidity of the electric motor assembly 8. The third preset condition includes the electric motor temperature being lower than a target electric motor temperature.

Otherwise, the second control device 12 is controlled to open the flow path between the second liquid-returning branch corresponding to the flash-tank 13 and the flash-tank 13, and close the flow path between the second liquid-returning to the evaporator 14 and the evaporator 14, and the following step S132 is executed.

At step S132, the temperature and humidity of the frequency converter heat dissipation assembly 24 in the frequency converter, the temperature of the frequency converter assembly, and the temperature of the electric motor assembly 8 are measured.

When the temperature and humidity of the frequency converter heat dissipation assembly 24 do not meet the first preset condition, the third control device on the second cooling branch for performing heat exchange with the frequency converter heat dissipation assembly 24 is controlled to control the flow of a refrigerant liquid that flows through the second cooling branch for performing heat exchange with the frequency converter heat dissipation assembly 24, thereby realizing adjustment of the temperature and humidity of the frequency converter heat dissipation assembly 24. The first preset condition includes an in-cabinet temperature of the frequency converter heat dissipation assembly 24 being within a set interval of an in-cabinet temperature of the frequency converter heat dissipation assembly 24.

When the temperature of the frequency converter power assembly does not meet the second preset condition, the first control device 21 located on the first liquid-taking flow path is controlled to be switched on, and the first control device 21 located on the first liquid-returning flow path is controlled to control a flow of a refrigerant liquid that flows through the first heat exchange assembly 4, so as to adjust the temperature of the frequency converter power assembly. The second preset condition includes the temperature of the frequency converter power assembly being within a set interval of a target temperature of the frequency converter power assembly.

When the temperature of the electric motor assembly 8 does not meet the third preset condition, the third control device on the second cooling branch for performing heat exchange with the electric motor assembly 8 is controlled to control a flow of a refrigerant liquid that flows through the second cooling branch for performing heat exchange with the electric motor assembly 8, thereby realizing adjustment of the temperature and humidity of the electric motor assembly 8. The third preset condition includes the electric motor temperature being within a set interval of a target temperature of the electric motor.

For details of the terms and the implementation principles involved in the second embodiment of the disclosure, reference can be made to the above embodiments of the disclosure, and will not be described here again.

In the disclosure, a second control device located on a second liquid-returning flow path and a first control device arranged on a first liquid-taking flow path and/or a first liquid-returning flow path are controlled by a controller assembly, such that dual-stage adjustment can be realized. As a result, it is ensured that a frequency converter works at a suitable temperature. Further, a differential pressure across the frequency converter can also be effectively adjusted, and the problems such as condensation, overtemperature, etc. under an extreme working condition can be solved.

It should be noted that the term "comprise", "include", or any other variant thereof herein is intended to encompass a non-exclusive inclusion, such that a process, method, article, or device that includes a series of elements not only comprises those elements, but also comprises other elements not explicitly listed, or elements that are inherent to such a process, method, article, or device. In the absence of more restrictions, the element defined by the phrase "comprising a/an ..." does not exclude the presence of a further identical element in the process, method, article or device that includes the element.

The serial numbers of the embodiments of the disclosure are only for description, and do not represent the superiority or inferiority of the embodiments.

Through the description of the foregoing embodiments, those skilled in the art can clearly understand that the method of the above embodiments can be implemented by software combined with a necessary universal hardware platform, and certainly, can also be implemented by hardware, but in many cases, the former is a better implementation. On the basis of such understanding, the technical solution of the disclosure, in essence, or its contribution to the prior art may be embodied in the form of a software product. The computer software product is stored in a storage medium (for example, an ROM/RAM, a magnetic disk and an optical disk), and includes several instructions used to cause a terminal (which may be a mobile phone, a computer, a server, an air conditioner or a network device, etc.) to execute the method in the embodiments of the disclosure.

The embodiments of the disclosure are described above with reference to the accompanying drawings. However, the disclosure is not limited to the implementations above. The implementations above are merely illustrative rather than limitative. In light of the teachings of the disclosure, a person of ordinary skill in the art may further use various forms without departing from the spirit of the disclosure and the protection scope of the claims, and these forms all fall within the protection scope of the disclosure.

## Claims

1. A frequency converter cooling system, comprising:
a frequency converter cooling flow path, which includes a first liquid-taking flow path, a first heat exchange assembly and a first liquid-returning flow path, and performs heat exchange with a frequency converter assembly via the first heat exchange assembly;
a first control device, which is provided in a quantity of at least one, and which is arranged on the first liquid-taking flow path and/or the first liquid-returning flow path for controlling a flow of a refrigerant liquid that flows through the first liquid-taking flow path and/or for controlling a flow of a refrigerant liquid that flows through the first liquid-returning flow path;
a second control device, which is arranged on the first liquid-returning flow path for controlling a flowing direction of the refrigerant liquid that flows through the first liquid-returning flow path, so that evaporative heat dissipation of a corresponding power can be performed on a refrigerant liquid discharged in each flowing direction; and
a controller assembly, which is electrically connected to the frequency converter assembly, the first control device and the second control device for controlling the operation of the first control device and the operation of the second control device.

2. The system according to claim 1, wherein the controller assembly is configured for controlling the operation of the first control device and/or the operation of the second control device according to an output power of the frequency converter assembly.

3. The system according to claim 2, wherein the system further comprises a module temperature measurement device, which is arranged on the first heat exchange assembly, and which is electrically connected to the controller assembly for collecting a temperature of the frequency converter assembly and for uploading a temperature parameter to the controller assembly, so that the controller assembly controls the operation of the first control device and/or the operation of the second control device according to the collected temperature.

4. The system of according to claim 1, wherein the first liquid-returning flow path comprises a first liquid-returning branch and at least two second liquid-returning branches, wherein each of the second liquid-returning branches is configured for discharging a flowing refrigerant liquid, so that evaporative heat dissipation of a corresponding power can be performed on the discharged refrigerant liquid, and wherein an output end of the first liquid-returning branch is connected to the at least two second liquid-returning branches, wherein the second control device is configured for controlling connection and disconnection between the first liquid-returning branch and the at least two second liquid-returning branches, so as to control a flowing direction of the refrigerant liquid that flows through the first liquid-returning branch, and wherein when the first control device is arranged on the first liquid-returning flow path, the first control device is arranged on the first liquid-returning branch.

5. The system according to claim 4, wherein the second control device is provided in a quantity corresponding to the quantity of the second liquid-returning branches, and wherein the second control devices are respectively arranged on the corresponding second liquid-returning branches.

6. The system according to claim 1, wherein the system further comprises: at least one second cooling branch that is connected to the frequency converter cooling flow path in parallel, the second cooling branch comprising a second heat exchanger for performing heat exchange with the frequency converter assembly.

7. The system according to claim 6, wherein the second cooling branch further comprises a third control device, which is provided in a quantity corresponding to the quantity of the second cooling branch, and which is located upstream of the corresponding second heat exchanger, wherein the third control device is electrically connected to the controller assembly for receiving an instruction from the controller assembly to control a flow of a refrigerant liquid that flows through the second cooling branch.

8. The system according to claim 1, wherein the system further comprises a plurality of humidity measurement devices, each of which is electrically connected to the controller assembly for collecting humidity of the frequency converter assembly and for uploading a humidity parameter to the controller assembly.

9. The system according to claim 1, wherein the frequency converter assembly comprises at least one of a frequency converter power assembly, an electric motor assembly and a frequency converter heat dissipation assembly.

10. An apparatus with a frequency converter, comprising a refrigeration apparatus unit, a frequency converter assembly and the frequency converter cooling system of any one of claims 1-9, wherein the refrigeration apparatus unit comprises a condenser, an evaporator and a flash-tank, which are sequentially connected, wherein an input end of the first liquid-taking flow path of the frequency converter cooling flow path and an input end of the at least one second cooling branch are both connected to an output end of the condenser, and wherein output ends of the at least two second liquid-returning branches are respectively connected to an input end of the evaporator and an input end of the flash-tank.

11. A frequency converter cooling method, which is applied to the apparatus with a frequency converter of claim 9, **characterized in that** the method comprises steps of:
acquiring (S11) an output power of a frequency converter power assembly;
determining (S12) whether an output power of the frequency converter assembly meets a first preset condition, wherein the first preset condition comprises: the output power of the frequency converter assembly being less than a set minimum power, or the output power of the frequency converter assembly being greater than or equal to a set maximum power; and
controlling (S13), if the first preset condition is met, a second control device located on a second liquid-returning branch corresponding to a flash-tank to close a flow path between the second liquid-returning branch corresponding to the flash-tank and the flash-tank, and controlling a second control device located on a second liquid-returning branch corresponding to an evaporator to open a flow path between the second liquid-returning branch corresponding to the evaporator and the evaporator, so as to ensure a reflux refrigerant liquid entering the evaporator;
otherwise, controlling the second control device located on the second liquid-returning branch corresponding to the flash-tank to open the flow path between the second liquid-returning branch corresponding to the flash-tank and the flash-tank, and controlling the second control device located on the second liquid-returning branch corresponding to the evaporator to close the flow path between the second liquid-returning branch corresponding to the evaporator and the evaporator.

12. The method according to claim 11, **characterized in that** the method further comprises steps of:
acquiring (S14) a temperature of the frequency converter power assembly;
determining (S15) whether the temperature of the frequency converter power assembly meets a second preset condition, wherein the second preset condition comprises: the temperature of the frequency converter power assembly being within a set interval of temperature of the frequency converter power assembly; and
controlling (S16), if the second preset condition is met, a first control device located on a first liquid-taking flow path to be switched on, and controlling a first control device on a first liquid-returning flow path, so as to control the flow of the first liquid-returning flow path per unit of time;
otherwise, controlling the first control device located on the first liquid-returning flow path to be switched on, and controlling the first control device on the first liquid-taking flow path, so as to control the flow of the first liquid-taking flow path per unit of time.

13. The method according to claim 11 or 12, **characterized in that** the method further comprises steps of:
acquiring (S17) a temperature of an electric motor assembly;
determining (S18) whether the temperature of the electric motor assembly meets a third preset condition, wherein the third preset condition comprises the temperature of the electric motor being lower than a target temperature of the electric motor; and
controlling (S19), according to a determination result, a third control device corresponding to the electric motor assembly to start, so as to adjust the temperature and humidity of the electric motor assembly.

14. The method according to claim 13, **characterized in that** the method further comprises steps of:
acquiring (S20) a temperature of a frequency converter heat dissipation assembly;
determining (S21) whether the temperature of the frequency converter heat dissipation assembly meets a first preset condition, wherein the first preset condition comprises: an in-cabinet temperature of the frequency converter heat dissipation assembly being within a set interval of an in-cabinet temperature of the frequency converter heat dissipation assembly; and
controlling (S22), according to a determination result, a third control device corresponding to the frequency converter heat dissipation assembly to start, so as to adjust the temperature and humidity of the frequency converter heat dissipation assembly.
